# EUROPÄISCHE PATENTSCHRIFT

(11) **EP 0 931 332 B1**
(45) Veröffentlichungstag und Bekanntmachung des Hinweises auf die Patenterteilung: **24.01.2007**
(21) Anmeldenummer: 97911125.9
(22) Anmeldetag: 01.10.1997
(51) Int. Cl.: H01L 21/268, H01L 21/027

(54) **VERFAHREN ZUM TRENNEN ZWEIER MATERIALSCHICHTEN VONEINANDER**
METHOD FOR SEPARATING TWO MATERIAL LAYERS
PROCEDE DE SEPARATION DE DEUX COUCHES DE MATERIAU

(30) Priorität: 01.10.1996 DE 19640594
(43) Veröffentlichungstag der Anmeldung: 28.07.1999
(73) Patentinhaber: Osram Opto Semiconductors GmbH & Co. OHG, 93049 Regensburg (DE)
(72) Erfinder: KELLY, Michael, K., D-85354 Freising (DE); AMBACHER, Oliver, D-85375 Neufahrn (DE); STUTZMANN, Martin, D-85435 Erding (DE); BRANDT, Martin, S., D-80809 München (DE); DIMITROV, Roman, D-81827 München (DE); HANDSCHUH, Robert, D-84518 Garching (DE)
(74) Vertreter: Epping - Hermann - Fischer
(86) Internationale Anmeldenummer: PCT/DE1997/002261
(87) Internationale Veröffentlichungsnummer: WO 1998/014986

(56) Entgegenhaltungen:
- DE-A- 3 508 469
- US-A- 4 448 636
- KELLY M. K. ET AL: "Optical patterning of GaN films" APPLIED PHYSICS LETTERS, Bd. 69, Nr. 12, 16.September 1996, USA, Seiten 1749-1751, XP002051249

## Beschreibung

Die Erfindung bezieht sich auf ein Verfahren zum Trennen zweier Materialschichten voneinander, insbesondere zum Trennen einer Halbleiterschicht von einem Substrat. Weiterhin bezieht sie sich auf nach diesem Verfahren hergestellte elektronische Bauelemente.

Unter Materialschichten sind hier sowohl Schichten aus einem einzigen Material als auch Schichtenfolgen oder Schichtstrukturen aus verschiedenen Materialien zu verstehen.

Die Herstellung von Produkten aus Halbleitern, wie elektronische und optoelektronische Bauelemente, bedarf typischerweise mehrerer Prozeßschritte, einschließlich den zum Wachstum von Halbleiterkristallen und Halbleiterschichten notwendigen Prozessen, und zur örtlich selektiven Entfernung und Strukturierung der Schichten. Viele Bauelemente bestehen zum Teil aus Schichtfolgen von ungleichen Halbleitermaterialien, die in Einkristallform epitaktisch auf einem Substrat gewachsen werden.

Als Prozeßschritte für die Strukturierung von Halbleiterschichten oder die Trennung zweier Halbleiterschichten voneinander werden meist Ätzverfahren eingesetzt, die die Halbleiterschichten von der Halbleiteroberfläche her abtragen. Solche Prozesse verlaufen oft sehr langsam und benötigen korrosive Chemikalien. Darüberhinaus gibt es nicht für jedes der bekannten Halbleiter-Materialsysteme ein Ätzverfahren, das mit einem vertretbaren Aufwand eine Strukturierung entsprechender Schichten ermöglicht.

Insbesondere sind die Halbleitermaterialien Indium-, Gallium- und Aluminiumnitrid (InN, GaN und AlN) und ihre Mischkristalle oder Legierungen, die im folgenden Text mit "Gruppe III-Nitriden" zusammengefaßt werden, sehr schwierig chemisch zu ätzen. In diesen Materialsystemen steht derzeit kein zuverlässiges naßchemisches Ätzverfahren zur Verfügung. Es muß daher das technisch sehr aufwendige Verfahren des Reaktiv-Ionen-Ätzens (Trockenätzen) eingesetzt werden. Diese Methode erlaubt aber nur relativ geringe Ätzraten und benötigt giftige und toxische Gase (z.B. Bortrichlorid). Weil Ätzverfahren auf die Oberfläche wirken, ist es meist nötig, die Ätzrate und -dauer genau zu kontrollieren, um die gewünschte Tiefe zu erreichen.

Weiterhin sind für manche Halbleitermaterialien, zum Beispiel und insbesondere für die Gruppe III-Nitride, Volumenkristalle aus denselben oder gitterangepaßten Halbleitermaterialien nicht oder nur mit großem technischen Aufwand herstellbar. Substrate zum Aufwachsen derartiger Halbleiterschichten stehen daher nur sehr beschränkt zur Verfügung. Oftmals werden aus diesem Grund zum Wachstum dieser Halbleiterschichten als Ersatz Substrate aus anderen Materialien und mit unzureichenden Eigenschaften für nachfolgende Prozeßschritte oder für den Betrieb des Bauelements verwendet. Zum Wachstum von Gruppe III-Nitrid-Schichten sind dies zum Beispiel Saphir- oder Siliziumkarbid-Substrate.

Diese "Ersatz"-Substrate bringen Probleme wie unpassende Atomgitterabstände und unterschiedliche thermische Ausdehnungskoeffizienten mit sich, die sich negativ auf die Materialqualität der auf ihnen gewachsenen Halbleiterschichten auswirken. Darüber hinaus sind manche Prozeßschritte, wie das bekannte Spalten von Halbleiterschichten zur Herstellung von Resonatorspiegeln von Laserdioden aus GaAs, mit diesen Substraten schwierig oder gar unmöglich.

Um diese Probleme zu bewältigen sind bislang verschiedene zum Ätzen alternative Verfahren bekannt geworden, um Halbleiterschichten oder andere Schichten voneinander oder von einem störenden Substrat zu trennen.

In E. Yablonovitch et al., Appl. Phys. Lett. 51, 2222 (1987), U.S. Patent 4,846,931, Thomas J. Gmitter and E. Yablonovitch, 11. Juli 1989 ist vorgeschlagen, im Materialsystem GaAs/AlAs beim Herstellungsprozeß der Bauelemente AlAs-Opferschichten zu implementieren, die naßchemisch aufgelöst werden können. Dies ermöglicht die Trennung von Schichten oder Strukturen vom Substrat. Diese Methode ist wegen der geringen lateralen Ätzgeschwindigkeit aber sehr zeitaufwendig. Für Gruppe III-Nitride gibt es darüberhinaus keine naßchemische Ätze.

Im US 4,448,636 ist eine Methode zur Entfernung von Metallfilmen von einem Substrat beschrieben. Hierbei wird der Metallfilm durch Licht erhitzt. Eine organische Opferschicht zwischen Substrat und Metallfilm wird durch die zugeführte Wärme verdampft und erlaubt die Entfernung der Metallschicht. Die Verwendung von organischen Zwischenschichten ist insbesondere beim epitaktischen Wachstum von Gruppe III-Nitriden nicht einsetzbar.

Eine vergleichbare Methode wurde zur Entfernung von Siliziumdioxid-Schichten von Galliumarsenid ist in Y.-F. Lu, Y. Aoyagi, Jpn. J. Appl. Phys. **34,** L1669 (1995) beschrieben. Auch in diesem Falle wird eine organische Zwischenschicht durch Lichtabsorption erhitzt und die SiO₂ Schicht abgehoben.

Aus Y.-F. Lu et al., Jpn. J. Appl. Phys. 33, L324 (1994) ist weiterhin die Separation von SiO₂-Streifen von einer GaAs-Schicht mit Hilfe eines Excimer-Lasers bekannt.

In der DE 35 08 469 C2 ist ein Verfahren zum Strukturieren von auf einem transparenten Substrat aufgebrachten Schichtfolgen beschrieben, bei dem die zu strukturierenden Schichten lokal durch ein transparentes Substrat hindurch mit Laserstrahlung bestrahlt wird, die in der zu strukturierenden Schicht absorbiert wird.

Weiterhin ist die sogenannte Laser-Ablation auf viele Materialsysteme angewandt worden um Material zu entfernen. Jedoch wird bei dieser Methode immer die Oberfläche destruktiv abgetragen, eine Trennung in zwei weiter zu verwendende Teile ist nicht möglich.

Spezifisch für Gruppe III-Nitride ist in Leonard und Bedair, Appl. Phys. Lett. **68**, 794 (1996), das Ätzen von GaN mit einem Laserpuls unter HCl-Gas beschrieben und auf eine photochemische Reaktion unter Beteiligung von Salzsäure zurückgeführt.

In Morimoto, J. Electrochem. Soc. **121**, 1383 (1974) und Groh et al., physica status solidi (a) **26**, 353 (1974)) ist die thermisch aktivierte Zersetzung von GaN beschrieben.

In Kelly et al., Appl. Phys. Lett. 69 (12), 16. Sept. 1996, S. 1749-1751 ist gezeigt, daß Gruppe III-Nitride laserinduziert zu thermisch aktivierter Zersetzung gebracht werden können. Es handelt sich bei diesem Verfahren jedoch ebenfalls um ein auf die Oberfläche der Halbleiterschicht wirkendes Verfahren, das insbesondere auch zu der Zerstörung der Oberfläche führt.

Die Aufgabe der vorliegenden Erfindung besteht darin, ein verbessertes Verfahren zum Trennen zweier Materialschichten voneinander zur Verfügung zu stellen, bei dem keine oder nur eine geringfügige Zerstörung der freien Oberflächen der Halbleiterschichten auftritt. Es soll insbesondere ein Verfahren zum Trennen von Gruppe III-Nitrid-Schichten von Saphir- oder SiC-Substraten entwickelt werden.

Diese Aufgabe wird durch ein Verfahren mit den Merkmalen des Anspruches 1 gelöst. Vorteilhafte Weiterbildungen dieses Verfahrens sind Gegenstand der Unteransprüche 2 is 15.

Erfindungsgemäß ist bei dem Verfahren der eingangs genannten Art vorgesehen, daß durch eine der beiden Materialschichten hindurch die Grenzfläche oder ein Bereich in der Nähe der Grenzfläche zwischen den beiden Schichten mit elektromagnetischer Strahlung bestrahlt wird und daß eine Materialschicht an oder in der Nähe der Grenzfläche durch Absorption der Strahlung zersetzt wird.

Dieses Verfahren ist eine Alternative zu naß- und trockenchemischen Atzprozessen, wie sie in der Halbleitertechnologie zur Strukturierung und Herstellung von einzelnen Schichten und Bauelementen eingesetzt werden. Es unterscheidet sich von diesen im Wesentlichen dadurch, daß es direkt auf einen internen Bereich an der Grenzfläche zwischen den beiden Schichten und nicht auf die freie Oberfläche wirkt. Dies erlaubt es unter anderem, die gewünschte Strukturierungstiefe direkt zu realisieren statt sie beispielsweise mittels genauer Vorgabe der Ätzdauer und -geschwindigkeit zu bestimmen. Bei dem erfindungsgemäßen Verfahren erfolgt auch keine Zerstörung einer der beiden Materialschichten. Dies führt zu einer neuen Möglichkeit, Schichtsysteme voneinander oder von dem Substrat zu lösen. Freistehende Bauelemente oder Schichten besitzen Vorteile bei weiteren Prozeßschritten; sie eignen sich z. B. als Substrate für die Homoepitaxie ohne die Probleme der Gitterfehlanpassung und der Differenzen in den thermischen Ausdehnungskoeffizienten, oder zur Herstellung von optischen Bauelementen (Laserdioden) durch die Möglichkeit des Spaltens, unabhängig von der Substratspaltbarkeit. Der Transfer von Schichten, Schichtsystemen und Bauelementen aus Gruppe III-Nitrid-Materialien auf andere Substrate ermöglicht die Kompatibilität und Integration von Gruppe III-Nitriden mit anderen technologisch relevanten Halbleitersystemen wie Silizium.

Das Verfahren ermöglicht die Trennung von Schichten eines Schicht-Substrat-Systems durch die direkte, sehr lokale Wirkung auf interne Grenzflächen oder grenzflächennahe Bereiche. Allgemein kann das hier beschriebene Verfahren auf Materialsysteme angewendet werden, in denen die zu trennende Grenzfläche mit elektromagnetischer Strahlung, insbesondere mit Licht erreichbar ist, die Strahlung von einem Material an dieser Grenzfläche absorbiert wird, und in denen sich ein Material in der Nähe der Grenzfläche durch die Absorption von Licht oder Lichtpulsen zersetzen läßt. Das Verfahren wird erleichert, wenn mindestens ein Zersetzungsprodukt gasförmig ist. Als Halbleiter für diesen Prozeß eignen sich u.a. die Gruppe III-Nitride, oxidische Materialien, und Si₃N₄,

Optoelektronische Bauelemente wie Leuchtdioden und Halbleiterlaser und elektronische Bauelemente wie Transistoren, Dioden, Oberflächenwellen-Bauelemente werden typischerweise in großer Zahl auf einem einzelnen Substrat hergestellt. Hier kann das beschriebene Verfahren der lichtinduzierten Strukturierung zur Trennung der einzelnen Bauelemente verwendet werden. Die Separation der Bauelemente vom Substrat kann wie bereits erwähnt durch die Zersetzung einer Opferschicht erfolgen, die während des Fertigungsprozesses unter oder über die zu trennende Fläche eingebracht werden muß. Hierzu eignen sich dünne InGaN Schichten aufgrund ihrer vergleichsweise geringen Bandlücke und chemischen Stabilität besonders.

Die Produktion freistehender Schichten und Schichtfolgen erlaubt den Transfer von Schichten aus Gruppe III-Nitriden auf andere Substrate (z.B. Silizium), die sich in ihren strukturellen, mechanischen und thermischen Eigenschaften stark von denen der Gruppe III-Nitride unterscheiden können. Die Verfahrensweise erlaubt die Kombination von Leuchtdioden und Halbleiterlasern aus Gruppe III-Nitriden mit konventionellen Trägermaterialien zur Herstellung flacher Bildschirme oder die Integration solcher Bauelemente in Schaltungen und integrierte Schaltkreise. Freistehende Schichtstrukturen können auch als optische Wellenleiter, und Lichtkoppler benutzt werden. Wenn dies mit einem Beugungsgitter strukturiert ist, kann das Licht durch das Gitter eingekoppelt werden. Schichten von spezifischer Dicke können auch als optische Filter angewendet werden.

Mittels Bestrahlung durch eine Maske, Bestrahlung mit dem Interferenzmuster zusammengebrachter kohärenter Lichtstrahlen, Holographie, oder durch serielle oder gleichzeitige Bestrahlung verschiedener ausgewählter Stellen kann eine laterale Strukturierung einer der Materialschichten erzeugt werden.

Wesentliche Schritte bei dem erfindungsgemäßen Verfahren sind:
(i) Identifizierung, Auswahl oder Herstellung einer zu trennenden Grenzfläche in dem gewünschten Schichtsystem, welche mit der zur Trennung zu benutzenden Strahlung erreichbar ist,
(ii) Identifizierung eines Materials, oder Einbau eines Materials als Opferschicht an der Grenzfläche, das das eingestrahlte Licht absorbiert, oder
(iii) Identifizierung oder Einbau eines Materials als Opferschicht in der Grenzflächennähe, das durch das absorbierte Licht oder der daraus resultierenden Energie zur Zersetzung gebracht werden kann und bei der Zersetzung ein gasförmiges Produkt in ausreichender Menge erzeugt und
(iv) Beleuchtung mit Strahlung einer ausgewählten Wellenlänge und Intensität, so daß die Strahlung hauptsächlich von der zu trennenden Grenzfläche oder der Opferschicht absorbiert wird und dabei die Zersetzungsreaktion anregt, wobei im Falle transparenter Substrate die Grenzfläche oder Opferschicht auch durch das Substrat hindurch beleuchtet werden kann.

Das erfindungsgemäße Verfahren ist insbesondere auch anwendbar zur Strukturierung von Halbleiterschichten, bestehend aus Gruppe III-Nitriden, die z. B. auf SiC- oder SaphirSubstraten aufgebracht sind.

Weitere Vorteile und vorteilhafte Weiterbildungen des erfindungsgemäßen Verfahrens ergeben sich aus den im Folgenden in Verbindung mit den Figuren 1 bis 9 beschriebenen Ausführungsbeispielen. Es zeigen:
Figur 1 eine schematische Darstellung eines ersten Ausführungsbeispieles,
Figur 2 eine schematische Darstellung eines zweiten Ausführungsbeispieles,
Figur 3 eine schematische Darstellung eines dritten Ausführungsbeispieles,
Figur 4 eine schematische Darstellung eines vierten Ausführungsbeispieles,
Figur 5 eine schematische Darstellung eines fünften Ausführungsbeispieles,
Figur 6 eine schematische Darstellung eines sechsten Ausführungsbeispieles,
Figur 7 eine schematische Darstellung eines siebten Ausführungsbeispieles,
Figur 8 eine schematische Darstellung eines achten Ausführungsbeispieles und
Figur 9 eine schematische Darstellung eines neunten Ausführungsbeispieles.

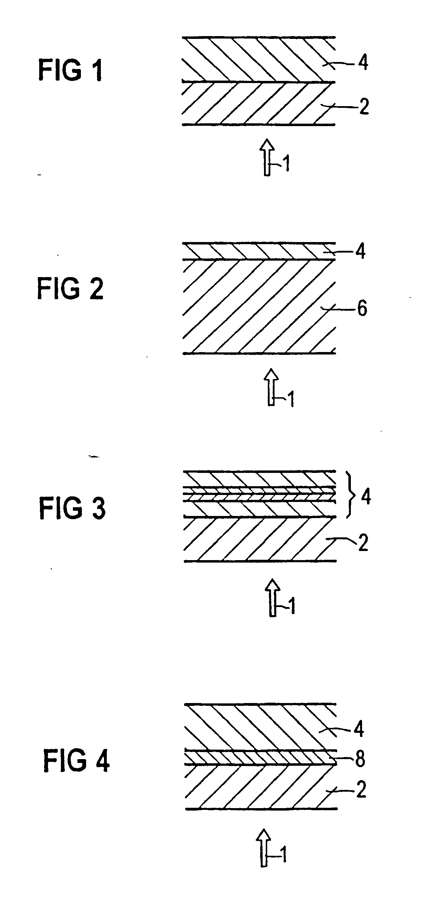

Bei dem Ausführungsbeispiel von Figur 1 wird eine Grenzfläche eines Schichtsystems aus einer ersten 2 und einer zweiten Halbleiterschicht 4 mit einem Lichtstrahl 1 durch die erste Halbleiterschicht 2 hindurch bestrahlt und das Licht im Material der zweiten Halbleiterschicht 4 stark absorbiert. Die erste Halbleiterschicht 2 ist für den Lichtstrahl 1 durchlässig.

In den Figuren sind gleiche oder gleichwirkende Bestandteile jeweils mit denselben Bezugszeichen versehen.
Die in der zweiten Halbleiterschicht 4 vorwiegend in der Nähe der Grenzfläche zwischen den beiden Halbleiterschichten 2,4 absorbierte Energie induziert z. B. eine Zersetzung des Halbleitermaterials der zweiten Halbleiterschicht 4 in diesem Bereich, so daß es zu einer Trennung der beiden Halbleiterschichten 2,4 kommt. Zersetzungsmechanismen können z. B. Sublimation oder chemische Reaktionen sein. Die Zersetzung kann dabei sowohl thermisch wie photochemisch initiiert werden.
Die Trennung wird besonders unterstützt, wenn bei der Zersetzung gasförmige Produkte entstehen.

Es ist jedoch auch möglich, daß die in der Halbleiterschicht 4 absorbierte Energie in das Halbleitermaterial 2 diffundiert und dort die Zersetzung stattfindet. Die relative Dicke der beiden Halbleitermaterialien kann dabei stark variieren, und ist nicht notwendigerweise, wie in der Figur 1 dargestellt, gleich groß.

Eine viel verwendete Methode Halbleitermaterialien herzustellen ist das Aufwachsen auf Substraten. Im Bezug auf das hier dargestellte Verfahren ist die Unterscheidung zwischen Substrat und Halbleitermaterial nicht relevant. Eine Möglichkeit ist, daß die Halbleiterschichten 2,4 auf einem Substrat gewachsen sind, und die Trennung an der Grenzfläche zwischen den Halbleiterschichten 2,4 stattfindet.

Bei dem Ausführungsbeispiel von Figur 2 wird eine Halbleiterschicht 4 von einem Substrat 6 getrennt. Dazu erfolgt die Bestrahlung der Halbleiterschicht 4 mit Licht 1 durch das Substrat 6 hindurch und die Strahlungsenergie wird im Material der Halbleiterschicht 4 absorbiert. Je nach den Absorptionseigenschaften kann es jedoch auch möglich sein, die Grenzfläche durch die Halbleiterschicht 4 hindurch zu beleuchten, so daß das Substrat 6 die Lichtenergie absorbiert. Wie oben bereits dargestellt ist es jedoch nicht notwendig, daß die Zersetzung in dem absorbierenden Teil der Struktur stattfindet, die Energie kann ggf. auch in den anderen Teil diffundieren und dort die Zersetzung bewirken.

Die Halbleiterschichten 2,4 können entweder jeweils homogene Schichten aus einem Halbleiter sein, oder aus Schichtfolgen verschiedener Halbleiter bestehen, wie am Beispiel der Halbleiterschicht 4 in Figur 3 angedeutet. In diesen Schichtfolgen kann bereits ein konkretes Bauelement vor- oder fertigprozessiert vorliegen, auch in Form eines integrierten elektronischen oder optoelektronischen Schaltkreises. Alle diese Strukturen sollen im Sinne der Anmeldung als Halbleiterschichten verstanden werden.

Um die Absorption des Lichtes an der zu trennenden Grenzfläche zu verbessern und gezielt zu beeinflussen, kann entsprechend dem vierten Ausführungsbeispiel gemäß Figur 4 zwischen eine erste 2 und eine zweite Halbleiterschicht 4 oder zwischen Substrat 6 und Halbleiterschicht 4 (vgl. Figur 2) eine besonders absorbierende Schicht 8 eingefügt werden. Die absorbierende Schicht 8, z. B. eine Halbleiterschicht, besitzt beispielsweise eine optische Bandlücke, die kleiner ist, als die der umgebenden Materialien. Die Schicht 8 kann nun selbst zersetzt werden und dann als eine Opferschicht wirken. Es ist aber auch möglich, daß die absorbierte Energie diffundiert und in der Nähe der Schicht 8 zu einer Zersetzung und Trennung führt.

Möglich ist auch, daß die Energie in der Halbleiterschicht 4 absorbiert wird, diese jedoch zu stabil ist um zersetzt zu werden. In diesem Falle kann die Schicht 8 so gewählt werden, daß sie sich besonders einfach zersetzt, also wiederum als Opferschicht fungiert. Ein besonderer Vorteil des hier beschriebenen Verfahrens ist, daß die Schicht 8 kristallin und gitterangepaßt sein kann.

Die elektromagnetische Strahlung muß so gewählt werden, daß es die zu trennende Grenzfläche erreichen kann und dort ausreichend absorbiert wird. Dies kann im einfachsten Fall durch Beleuchtung mit einer Lampe, ggf. nach Filterung, geschehen. Reicht der so zur Verfügung stehende Photonenfluß nicht aus, kann die Beleuchtung auch mit einem geeigneten Laser durchgeführt werden.

Besonders im Fall einer thermischen Zersetzung kann wegen der thermischen Leitfähigkiet der Materialien schnell die Wärme aus dem zu zersetzenden Bereich wegdiffundieren. Es kann deshalb notwendig sein, die Lichtenergie in Form sehr kurzer Lichtpulse zuzuführen, um trotzdem die für die Zersetzung notwendige Temperatur zu erreichen.

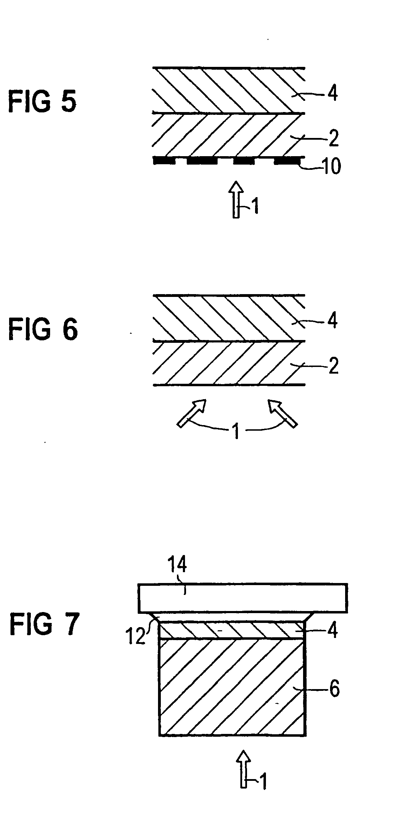

Das hier beschriebene Verfahren kann auch zur lateralen Strukturierung eingesetzt werden. Dies kann durch verschiedene Vorgehensweisen realisiert werden. Ein fokusierter Lichtstrahl kann benutzt werden, um sequentiell räumlich getrennte Punkte des Materials zu beleuchten und zur Zersetzung zu bringen. Wie bei dem Ausführungsbeispiel von Figur 5 gezeigt, kann eine Bestrahlungsmaske 10 eingesetzt werden, durch die ausgewählte Flächen der Probe entfernt werden können.

Ebenso ist entsprechend dem Ausführungsbeispiel von Figur 6 die Bestrahlung durch holographische Methoden (z.B. Beleuchtung mit einem Interferenzgitter) möglich, bei der Interferenzeffekte ausgenutzt werden mittels gleichzeitiger Bestrahlung mit mehr als einem kohärenten Strahl.

Der durch die Grenzflächenzersetzung abgetrennte Teil kann sehr dünn oder klein sein und somit mechanisch instabil und schlecht zu handhaben. Es ist möglich, diesen Teil gemäß dem Ausführungsbeispiel von Figur 7 vor oder nach der Trennung z.B. mittels Klebstoff 12 auf ein neues Trägermaterial 14 aufzubringen. Dies ist für den Fall des Fixierens vor der Grenzflächenzersetzung in Figur 7 exemplarisch dargestellt.

Nach der Trennung hat man dann eine vom Substrat 6 getrennte dünne Halbleiterschicht 4 auf dem Trägermaterial 14 zur Verfügung.

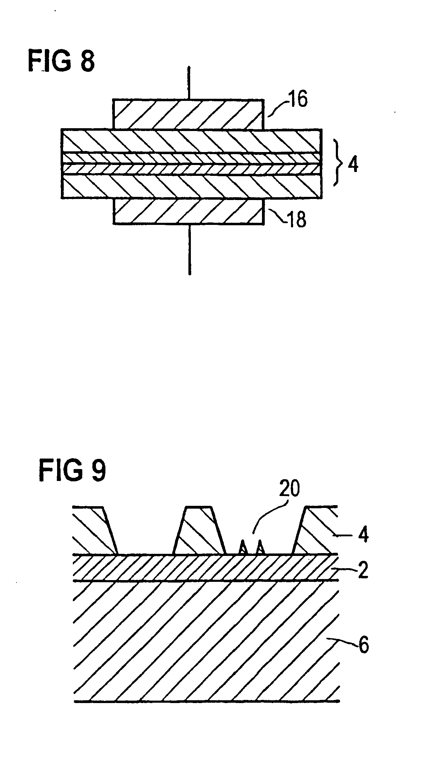

Besonders vorteilhaft kann das erfindungsgemäße Verfahren für die Herstellung von Schichtfolgen 4 oder ganzen Bauelementstrukturen elektronischer oder optoelektronischer Bauelemente eingesetzt werden, die auf nicht-leitenden Substraten ausgebildet werden. In diesen Fällen ist es häufig schwierig, zusätzlich zu dem jeweils an der substratabgewandten Seite der Schichtfolge 4 oder Bauelementstruktur angeordneten elektrischen Kontakt 16 an eine substratnah angeordnete Halbleiterschicht einen elektrischen Kontakt anzuordnen. Dazu sind meist komplizierte Ätzprozesse und die Bildung von Mesastrukturen erforderlich. Mit dem hier beschriebenen Verfahren lassen sich gemäß dem Ausführungsbeispiel von Figur 8 Schichtfolgen 4 oder ganze Bauelementstrukturen von nichtleitenden Substraten ablösen. Die nun freigelegten, vorher substratzugewandten Seiten der Schichtfolgen 4 oder Bauelementstrukturen sind nun für elektrische Kontakte 18 einfach zugänglich.

Die Realisierung dieses Verfahrens ist von dem Materialsystem abhängig. Eine bevorzugte Ausführungsform für Halbleitermaterialien benutzt ein Material an der zu trennenden Grenzfläche mit kleinerer Bandlücke als alle anderen Schichten oder Materialien auf einer Seite der Grenzfläche. Zur Bestrahlung wird eine Strahlungswellenlänge ausgewählt, bei der die Strahlung bis zur Grenzfläche eindringen kann, und die von dem Material mit kleinerer Bandlücke absorbiert wird. Dadurch muß eine Zersetzung in diesem oder einem benachbarten Material induzierbar sein.

Dieser Prozeß ist besonders für Schichten oder Schichtsysteme der Gruppe III-Nitride geeignet, da diese Materialgruppe einige für dieses Verfahren besondersn vorteilhafte physikalische Eigenschaften aufweist. Erstens ist es möglich, Gruppe III-Nitride durch die Absorption von einzelnen Lichtpulsen über ihre Zersetzungsstemperatur räumlich begrenzt und kontrolliert zu heizen. Bei den durch die Absorption von Lichtpulsen erzeugten Temperaturen setzt die Zersetzung der Nitride und die Bildung von gasförmigem Stickstoff ein (600°C - 1800°C, abhängig von der Zusammensetzung der Nitride). Zweitens ist es für die beschriebene Verfahrensweise hilfreich, daß die Schmelztemperaturen der Gruppe III-Nitride weit über den Zersetzungstemperaturen liegen, so daß es bei der Absorption intensiver Lichtpulse nicht zur Beeinträchtigung von Schichten und Bauelementen durch Schmelzen kommt. Drittens sind diese Halbleitermaterialien besonders für optische Prozesse geeignet, da sie in Abhängigkeit von der Wellenlänge des Lichts eine wohl definierte, scharfe Schwelle besitzen, eine direkte Bandlücke, an der sie von durchlässig zu vollständig absorbierend wechseln. Weiterhin läßt sich die Wellenlänge, bei der die Absorption einsetzt, durch die Mischkristalle der Nitride (InGaN und AlGaN) über einen weiten Spektralbereich variieren (Bandlücken: InN 1.9 eV, GaN 3.4 eV, AlN 6.2 eV). Außerdem werden Gruppe III-Nitride oft auf Saphirsubstraten hergestellt, die im gesamten optischen und ultravioletten Bereich transparent sind. Dies macht auch eine Beleuchtung der Schichten durch das Substrat möglich.

Falls die Zersetzung thermisch aktiviert wird, ist es wichtig, daß die entstehende Wärme auf die Grenzfläche oder die Opferschicht konzentriert werden kann, einerseits um die nötige eingestrahlte Intensität zu minimieren, andererseits um unerwünschte Effekte auf das umgebende Material auszuschließen. Da die lichterzeugte Wärmemenge durch die thermische Leitfähigkeit der Materialien schnell aus den heißen Volumen abgeleitet wird, muß die notwendige Temperatur in einer sehr kurzen Zeit erzeugt werden. Dies kann durch kurze Laserpulse realisiert werden. Für typische Wärmeleitfähigkeiten der Gruppe III-Nitride kann die absorbierte Energie durch die Verwendung von Laserpulsen mit einer Dauer von 1 ns bis 10 ns auf die Eindringtiefe des absorbierten Lichts oder die Dicke der Opferschicht konzentriert werden. Für die Strukturierung und Zersetzung von Gruppe III-Nitriden eignet sich z.B. ein "Q-switched" gepulster Nd:YAG Laser.

Als spezifische Ausführung für die lichtinduzierte Zersetzung der Materialien GaN und InGaN (Bandlücken zwischen 1.9 und 3.4 eV) kann die dritte harmonische Laserlinie eines Nd:YAG Lasers verwendet werden. Diese Laserlinie wird z.B. mit Hilfe eines nichtlinearen optischen Kristalls erzeugt und besitzt eine Wellenlänge von 355 nm (3.5 eV). GaN und InGaN Schichten absorbieren diese Lichtpulse und können zur Zersetzung gebracht werden. AlGaN Schichten und das meistens verwendete Saphirsubstrat sind für diese Wellenlänge transparent. Freistehende GaN und InGaN Schichten können direkt durch die Zersetzung der Grenzfläche Substrat-Schicht erzeugt werden. AlGaN-Schichten und -Bauelemente können durch die lichtinduzierte Zersetzung von dünnen GaN oder InGaN Opferschichten vom Substrat gelöst werden. In Figur 7 ist schematisch gezeigt wie eine GäN-Schicht 4 von einem beidseitig polierten Saphir-Substrat 6 zu trennen ist. Die Grenzfläche zwischen GaN und Saphir wird durch das Substrat hindurch mit einem einzelnen Laserpuls der Wellenlänge 355 nm beleuchtet. Die Laserstrahlung wird nahe der Grenzfläche bis zu einer Tiefe von ungefähr 100 nm vom GaN absorbiert, wodurch die Grenzfläche geheizt wird. Werden Temperaturen von mehr als 850°C erreicht, setzt die Zersetzung des GaN unter Bildung von Stickstoffgas ein. Für Pulsenergien über ungefähr 0,2 J/cm² genügt die Energiedichte zur vollständigen Zersetzung an der Grenze zwischen Substrat 6 und GaN-Schicht 4, wodurch die Bindung zwischen dem Substrat 6 und der GaN-Schicht 4 in der beleuchteten Fläche getrennt wird. Um die freistehende Schicht zu stabilisieren kann die Probe vor der Beleuchtung mit der Schichtseite unter Verwendung eines Harzes oder Wachses 12 auf eine Trägerscheibe oder Folie 14 geklebt sein. Ist die GaN-Schicht 4 durch die Zersetzungsreaktion vom Substrat 6 getrennt, läßt sich das Saphir-Substrat 6 abheben und die GaN-Schicht 4 bleibt auf der Trägerscheibe oder Folie 14 zurück. Nun läßt sich das Wachs oder das Harz in Aceton lösen und die GaN-Schicht bleibt als freistehende Schicht zurück.

Bei der Strukturierung von GaN-Schichten mittels Bestrahlung der Grenzfläche durch ein Saphirsubstrat hindurch können GaN-Strukturen mit nicht vertikalen, also schrägen Seitenflächen erzeugt werden, die sich, wie in Figur 9 gezeigt vom Zersetzungsort ausbreiten. Dieses Verhalten kann beispielsweise zum Erzeugen spitz- oder pyramidenförmig ausgebildeter Strukturen 20 ausgenutzt werden, wenn die laterale Breite des Interferenzgitters oder der Maske an die Schichtdicke angepaßt ist. Dieses Verhalten unterstützt auch die Herstellung freistehender Schichten.

Verschiedene Bauelemente aus Gruppe III-Nitriden können durch die beschriebene Verfahrensweisen strukturiert werden. Die Fertigung von periodischen Strichgittern und Oberflächenstrukturen mittels Beleuchtung mit einem Interferenzgitter kann vorteilhaft zur Herstellung von Bragg-Reflektoren und Distributed Feedback Lasern auf Gruppe III-Nitrid-Basis genutzt werden. Auch optische Dispersionsgitter, die ggf. auch für transmittiertes Licht benutzt werden können, lassen sich durch eine Variation der Dicke der Schicht mittels Strukturierung mit einem Interferenzgitter erzielen. Pyramidale Strukturen aus AlN und AlGaN können wegen ihrer negativen Elektronenaffinität als Kaltkathodenemitter z.B. in flachen Bildschirmen eingesetzt werden.

## Patentansprüche

1. Verfahren zum Trennen einer Halbleiterschicht von einem Substrat an einer Grenzfläche zwischen der Halbleiterschicht und dem Substrat, wobei die Halbleiterschicht und das Substrat erhalten bleiben, bei dem:
- ein Bereich an der Grenzfläche durch das Substrat oder die Halbleiterschicht hindurch mit elektromagnetischer Strahlung bestrahlt wird,
- durch Absorption der elektromagnetischen Strahlung in dem Bereich an der Grenzfläche eine Materialzersetzung an der Grenzfläche induziert wird, und
- die Halbleiterschicht nachfolgend vom Substrat getrennt wird.

2. Verfahren nach Anspruch 1, bei dem an der Grenzfläche eine Opferschicht angeordnet wird, die die elektromagnetische Strahlung absorbiert und dadurch zersetzt wird.

3. Verfahren nach Anspruch 2, bei dem die Opferschicht so gewählt wird, daß ihre optische Bandlücke kleiner als die Bandlücke einer der beiden Materialschichten ist.

4. Verfahren nach einem der Ansprüche 1 bis 3, bei dem die Energie der absorbierten Strahlung in Form von Wärme die Materialzersetzung induziert.

5. Verfahren nach einem der Ansprüche 1 bis 4, bei dem die elektromagnetische Strahlung in einem Bereich in der Nähe der Grenzfläche absorbiert wird, derart, dass die Energie der absorbierten elektromagnetischen Strahlung in Form von Wärme in eine temperaturempfindliche Opferschicht diffundiert und dort die Materialzersetzung bewirkt.

6. Verfahren nach einem der Ansprüche 1 bis 5, bei dem die Energie der absorbierten elektromagnetischen Strahlung zu einer Gasentwicklung auf Grund von chemischen Reaktionen, Sublimation, oder sonstigem Austreten von Gasen führt.

7. Verfahren nach einem der Ansprüche 1 bis 6, bei dem die Halbleiterschicht zur mechanischen Stabilisierung auf ein Trägermaterial aufgebracht wird.

8. Verfahren nach einem der Ansprüche 1 bis 7, bei dem der Bereich an der Grenzfläche mit elektromagnetischer Strahlung in Form eines oder mehrerer Lichtpulse bestrahlt wird.

9. Verfahren nach einem der Ansprüch 1 bis 8, bei dem im Bereich an der Grenzfläche mit Hilfe zweier oder mehrerer kohärenter Laserstrahlen ein Interferenzmuster in der Bestrahlung realisiert wird, das zu einer erhöhten lokalen Lichtintensität führt.

10. Verfahren nach einem der Ansprüche 1 bis 9, bei dem die Halbleiterschicht vollständig oder teilweise aus GaN, AlN, InN, oder ihren Mischkristallen, oder einer Schichtfolge, einer Schichtstruktur oder einer Bauelementstruktur aus GaN, AlN, InN, oder ihren Mischkristallen bestehen.

11. Verfahren nach Anspruch 10, bei dem das Substrat im Wesentlichen aus Saphir, LiAlO₂, LiGaO₂, MgAl₂O₄, ScAlMgO₄ oder SiC besteht.

12. Verfahren nach Anspruch 11, bei dem eine Halbleiterschicht aus GaN oder InₓGa₁₋ₓN von einem Saphirsubstrat getrennt wird mittels Beleuchtung durch das Saphirsubstrat mit der dritten Harmonischen eines Nd:YAG Lasers bei der Wellenlänge von 355 nm.

13. Verfahren nach Anspruch 12, bei dem der Nd:YAG Laser mit Hilfe eines Q-Switches gepulst wird.

14. Verwendung eines Verfahrens nach einem der Ansprüche 1 bis 13 zur Herstellung von freistehenden Bauelementstrukturen, eingeschlossen Dioden, lichtemittierende Dioden (LEDs), Halbleiterlaser, Transistoren, und Detektoren.

15. Verwendung eines Verfahrens nach einem der Ansprüche 1 bis 13 zur Herstellung von optischen Bauelementen, eingeschlossen Beugungsgitter, Dünnschichtfilter, Lichtkoppler und Wellenleiter.

## Claims

1. Process for separating a semiconductor layer from a substrate at an interface between the semiconductor layer and the substrate, the semiconductor layer and the substrate being preserved, in which:
- a region at the interface is exposed to electromagnetic radiation through the substrate or through the semiconductor layer,
- decomposition of material is induced at the interface by absorption of the electromagnetic radiation in the region at the interface, and
- the semiconductor layer is subsequently separated from the substrate.

2. Process according to Claim 1, in which a sacrificial layer which absorbs the electromagnetic radiation and becomes decomposed thereby is arranged at the interface.

3. Process according to Claim 2, in which the sacrificial layer is selected in such a way that its optical band gap is smaller than the band gap of one of the two layers of material.

4. Process according to one of Claims 1 to 3, in which the energy of the absorbed radiation induces the decomposition of material in the form of heat.

5. Process according to one of Claims 1 to 4, in which the electromagnetic radiation is absorbed in a region in the vicinity of the interface such that the energy of the absorbed electromagnetic radiation diffuses in the form of heat into a temperature-sensitive sacrificial layer and brings about the decomposition of material there.

6. Process according to one of Claims 1 to 5, in which the energy of the absorbed electromagnetic radiation leads to the evolution of gas as a result of chemical reactions, sublimation or other forms of gas generation.

7. Process according to one of Claims 1 to 6, in which the semiconductor layer is applied for mechanical stabilization on a support material.

8. Process according to one of Claims 1 to 7, in which the region at the interface is exposed to electromagnetic radiation in the form of one or more light pulses.

9. Process according to one of Claims 1 to 8, in which, in the region at the interface, using two or more coherent laser beams, an interference pattern is produced in the exposure, which leads to an increased local light intensity.

10. Process according to one of Claims 1 to 9, in which the semiconductor layer consists fully or partially of GaN, AlN, InN or mixed crystals thereof, or a layer sequence, a layer structure or a component structure of GaN, AlN, InN or mixed crystals thereof.

11. Process according to Claim 10, in which the substrate essentially consists of sapphire, LiAlO₂, LiGaO₂, MgAl₂O₄, ScAlMgO₄ or SiC.

12. Process according to Claim 11, in which a semiconductor layer of GaN or InₓGa₁₋ₓN is separated from a sapphire substrate by means of exposure through the sapphire substrate with the third harmonic of a Nd:YAG laser at the wavelength of 355 nm.

13. Process according to Claim 12, in which the Nd:YAG laser is pulsed using a Q switch.

14. Use of a process according to one of Claims 1 to 13 for producing cantilevered component structures, including diodes, light-emitting diodes (LEDs), semiconductor lasers, transistors and detectors.

15. Use of a process according to one of Claims 1 to 13 for producing optical components, including diffraction gratings, thin film filters, optical couplers and waveguides.

## Revendications

1. Procédé pour séparer une couche de semiconducteur d'un substrat au niveau d'une surface de délimitation entre la couche de semiconducteur et le substrat, la couche de semiconducteur et le substrat étant conservés, avec lequel :
- une zone au niveau de la surface de délimitation est irradiée avec un rayonnement électromagnétique à travers le substrat ou à travers la couche de semiconducteur,
- une désintégration du matériau est induite au niveau de la surface de délimitation par absorption du rayonnement électromagnétique dans la zone au niveau de la surface de délimitation et
- la couche de semiconducteur est ensuite séparée du substrat.

2. Procédé selon la revendication 1, avec lequel une couche sacrificielle est disposée sur la surface de délimitation, laquelle absorbe le rayonnement électromagnétique et est ainsi désintégrée.

3. Procédé selon la revendication 2, avec lequel la couche sacrificielle est choisie de telle sorte que son écart énergétique optique soit inférieur à l'écart énergétique de l'une des deux couches de matériau.

4. Procédé selon l'une des revendications 1 à 3, avec lequel l'énergie du rayonnement absorbé induit la désintégration du matériau sous forme de chaleur.

5. Procédé selon l'une des revendications 1 à 4, avec lequel le rayonnement électromagnétique est absorbé dans une zone à proximité de la surface de délimitation de telle sorte que l'énergie du rayonnement électromagnétique absorbé se diffuse sous forme de chaleur dans une couche sacrificielle sensible à la température et y provoque la désintégration du matériau.

6. Procédé selon l'une des revendications 1 à 5, avec lequel l'énergie du rayonnement électromagnétique absorbé provoque un dégagement gazeux en raison des réactions chimiques, de la sublimation ou d'autres gaz produits.

7. Procédé selon l'une des revendications 1 à 6, avec lequel la couche de semiconducteur est appliquée sur un matériau porteur en vue de la stabilisation mécanique.

8. Procédé selon l'une des revendications 1 à 7, avec lequel la zone au niveau de la surface de délimitation est irradiée avec un rayonnement électromagnétique sous la forme d'une ou plusieurs impulsions lumineuses.

9. Procédé selon l'une des revendications 1 à 8, avec lequel un modèle d'interférence est réalisé dans le rayonnement dans la zone au niveau de la surface de délimitation au moyen de deux rayons laser cohérents ou plus, lequel donne lieu à une intensité lumineuse locale accrue.

10. Procédé selon l'une des revendications 1 à 9, avec lequel la couche de semiconducteur se compose entièrement ou partiellement de GaN, d'AlN, d'InN ou de leurs cristaux mixtes ou encore d'une séquence de couches, d'une structure en couche ou d'une structure de composant en GaN, en AlN, en InN ou leurs cristaux mixtes.

11. Procédé selon la revendication 10, avec lequel le substrat se compose pour l'essentiel de saphir, de LiAlO₂, de LiGaO₂, de MgAl₂O₄, de ScAlMgO₄ ou de SiC.

12. Procédé selon la revendication 11, avec lequel une couche de semiconducteur en GaN ou en In_{X}Ga₁₋ₓN est séparée d'un substrat en saphir au moyen d'un éclairage à travers le substrat en saphir avec la troisième harmonique d'un laser Nd:YAG à la longueur d'onde de 355 nm.

13. Procédé selon la revendication 12, avec lequel des pulsations du laser Nd:YAG sont produites à l'aide d'un commutateur Q.

14. Utilisation d'un procédé selon l'une des revendications 1 à 13 pour produire des structures de composant libres, y compris des diodes, des diodes électroluminescentes (LED), des lasers à semiconducteur, des transistors et des détecteurs.

15. Utilisation d'un procédé selon l'une des revendications 1 à 13 pour produire des composants optiques, y compris des réseaux de diffraction, des filtres à couche mince, des coupleurs optoélectroniques et des guides d'onde.
